# EUROPEAN PATENT APPLICATION

(11) **EP 4 586 309 A2**
(43) Date of publication of application: **16.07.2025**
(21) Application number: 24214748.6
(22) Date of filing: 22.11.2024
(51) Int. Cl.: H01L 23/00

(54) **ELECTRONIC DEVICE**

(30) Priority: 19.12.2023 CN 202311743674
(71) Applicant: InnoLux Corporation, Jhu-Nan, Miao-Li County 350 (TW)
(72) Inventor: LIN, Ming-Chang, 350 Miao-Li County (TW)
(74) Representative: Straus, Alexander

(57) **Abstract**

An electronic device (1) includes a substrate (200) including a first bump metal layer (202) and a second bump metal layer (204) arranged in a first direction (X), an electronic unit (EU) including a third bump metal layer (102) overlapped with the first bump metal layer (202) and a fourth bump metal layer (104) overlapped with the second bump metal layer (204), and a bonding unit (BU) disposed between the first bump metal layer (202) and the third bump metal layer (204) and disposed between the second bump metal layer (204) and the fourth bump metal layer (104). A ratio of a width (PCx) of the third bump metal layer (102) to a width (PSx) of the first bump metal layer (202) is greater than or equal to 0.3 and less than or equal to 0.9 in the first direction (X).

## Description

### Field of the Disclosure

The present disclosure relates to an electronic device and particularly to an electronic device with a microelectronic unit.

### Background of the Disclosure

Due to the small sizes of the microscopic electronic unit, the sizes of the contact point of the electronic unit reduce, such that there is a significant size difference between the contact point of the electronic unit and the contact point of the substrate. When using solder to bond the electronic unit and the substrate, greater size difference between the contact points causes a considerable change of thickness of the contact point after bonding, which raises the risk of insufficient mechanical strength, further lowering the reliability of the electronic device.

### Summary of the Disclosure

This in mind, the present disclosure aims at providing an electronic device with specific size ranges of the bump metal layers of the electronic unit and the substrate included in the electronic device, so as to provide good mechanical strength and/or reliability of the electronic device.

This is achieved by an electronic device according to the claims. The dependent claims pertain to further developments and improvements.

As will be seen more clearly from the detailed description following below, an electronic device is provided by the present disclosure. The electronic device includes a substrate, an electronic unit, and a bonding unit. The substrate includes a first bump metal layer and a second bump metal layer, wherein the first bump metal layer and the second bump metal layer are arranged in a first direction. The electronic unit includes a third bump metal layer and a fourth bump metal layer, wherein the first bump metal layer is overlapped with the third bump metal layer, and the second bump metal layer is overlapped with the fourth bump metal layer. The bonding unit includes a first bonding member and a second bonding member, wherein the first bonding member is disposed between the first bump metal layer and the third bump metal layer, and the second bonding member is disposed between the second bump metal layer and the fourth bump metal layer. In the first direction, a ratio of a width of the third bump metal layer to a width of the first bump metal layer is greater than or equal to 0.3 and less than or equal to 0.9.

As will be seen more clearly from the detailed description following below, another electronic device is provided. The electronic device includes a substrate, an electronic unit, a bonding unit, and a connection wire. The substrate includes a first bump metal layer and a wire, wherein the first bump metal layer and the wire are arranged in a first direction. The electronic unit includes a body, a second bump metal layer, and an electrode, wherein the second bump metal layer and the electrode are respectively disposed on two sides of the body, and the first bump metal layer is overlapped with the second bump metal layer. The bonding unit includes a bonding member, wherein the bonding member is disposed between the first bump metal layer and the second bump metal layer. The connection wire is electrically connected to the electrode of the electronic unit and the wire of the substrate. In the first direction, a ratio of a width of the second bump metal layer to a width of the first bump metal layer is greater than or equal to 0.3 and less than or equal to 0.9.

These and other objectives of the present disclosure will no doubt become obvious to those of ordinary skill in the art after reading the following detailed description of the embodiment that is illustrated in the various figures and drawings.

### Brief Description of the Drawings

In the following, the disclosure is further illustrated by way of example, taking reference to the accompanying drawings. Thereof:
FIG. 1 to FIG. 3 schematically illustrate a bonding process of an electronic device according to a first embodiment of the present disclosure;
FIG. 4 schematically illustrates a bottom view of an electronic unit according to the first embodiment of the present disclosure;
FIG. 5 schematically illustrates a top view of a substrate according to the first embodiment of the present disclosure;
FIG. 6 to FIG. 8 schematically illustrate a bonding process of an electronic device according to a second embodiment of the present disclosure; and
FIG. 9 to FIG. 11 schematically illustrate a bonding process of an electronic device according to a third embodiment of the present disclosure.

### Detailed Description

The contents and effects of the present disclosure will be described in detail with reference to specific embodiments and drawings. It is noted that, for purposes of illustrative clarity and being easily understood by the readers, the following drawings may be simplified schematic diagrams, and elements therein may not be drawn to scale. The numbers and sizes of the elements in the drawings are just illustrative and are not intended to limit the scope of the present disclosure.

Certain terms are used throughout the specification and the appended claims of the present disclosure to refer to specific elements. Those skilled in the art should understand that electronic equipment manufacturers may refer to an element by different names, and this document does not intend to distinguish between elements that differ in name but not function. In the following specification and claims, the terms "comprise", "include" and "have" are open-ended fashion, so they should be interpreted as "including but not limited to...".

Spatially relative terms, such as "above", "on", "beneath", "below", "under", "left", "right", "before", "front", "after", "behind" and the like, used in the following embodiments just refer to the directions in the drawings and are not intended to limit the present disclosure. In the drawings, each figure schematically illustrates a common characteristic of method, structure, and/or materials used in certain embodiments. However, these figures should not be interpreted to define or limit the scope or characteristic of these embodiments. For example, in order to be clear, comparative sizes, thickness, and location of each layer, region, and/or structure may be shrunk or enlarged.

It should be understand that when one element or layer is "on" or "above" another element or layer or is "connected to" the another element or layer, it may be understood that the element or layer is directly on the another element or layer or directly connected to the another element or layer, and alternatively, another element or layer may be between the element or layer and the another element or layer (indirectly). On the contrary, when the element or layer is "directly on" the another element or layer or is "directly connected to" the another element or layer, it may be understood that there is no intervening element or layer between the element or layer and the another element or layer.

As disclosed herein, the term "identical" and the term "the same as" generally mean within 10% of the reported numerical value or range, or within 5%, 3%, 2%, 1%, or 0.5% of the reported numerical value or range.

The term "electrically connected" includes means of direct or indirect electrical connection. Two elements electrically connected to each other may be in direct contact with each other to transfer electrical signals, and there is no other element between them. Alternatively, two elements electrically connected to each other may be bridged through another element between them to transfer electrical signals. The term "electrically connected" may also be referred to as "coupled".

Although terms such as first, second, third, etc., may be used to describe diverse constituent elements, such constituent elements are not limited by the terms. The terms are used only to discriminate a constituent element from other constituent elements in the specification. The claims may not use the same terms, but instead may use the terms first, second, third, etc. with respect to the order in which an element is claimed. Accordingly, in the following description, a first constituent element may be a second constituent element in a claim.

It should be understood that according to the following embodiments, features of different embodiments may be replaced, recombined or mixed to constitute other embodiments without departing from the spirit of the present disclosure. The features of various embodiments may be mixed arbitrarily and used in different embodiments without departing from the spirit of the present disclosure or conflicting.

Comparisons of the length, thickness, width, height, radius, etc. between different elements in the following contents may be done by using an optical microscope (OM), a scanning electron microscope (SEM) or other suitable apparatuses, and may be done by using one photo or more than one photo.

An electronic device of the present disclosure may include a display device, a backlight device, an antenna device, a sensing device, a wearable device, a car-mounted device, or a tiled device, but not limited thereto. The electronic device may be a bendable, flexible, or rollable electronic device. The display device may include a self-luminous display device or a non-self-luminous display device, but not limited thereto. The electronic device may, for example, include liquid crystal, a light emitting diode (LED), a fluorescence material, a phosphorescence material, quantum dot (QD), other suitable display media, or any combination of the aforementioned materials, but not limited thereto. The antenna device may, for example, include liquid crystal antenna or non-liquid-crystal antenna, but not limited thereto. The sensing device may, for example, be a sensing device used for detecting change in capacitances, light, heat, or ultrasound, but not limited thereto.

The electronic device may include electronic units, in which the electronic units may include a passive element or an active element, and for example include a capacitor, a resistor, an inductor, a diode, etc. The diode may include light emitting diode or photodiode, but not limited thereto. The light emitting diode may, for example, include an organic light emitting diode (OLED), a mini light emitting diode (mini LED), a micro light emitting diode (micro LED), or a quantum dot light emitting diode (e.g., QLED or QDLED), but not limited thereto. The tiled device may, for example, include a tiled display device or a tiled antenna device, but not limited thereto. It is noted that the appearance of the electronic device may be, for example, rectangular, circular, polygonal, a shape with curved edges, curved or other suitable shapes. The electronic device may have peripheral systems such as a driving system, a control system, a light source system, a shelf system, etc. to support display device, antenna device, wearable device (e.g., includes augmented reality or virtual reality), car-mounted device (e.g., include wind shield of car), or tiled device.

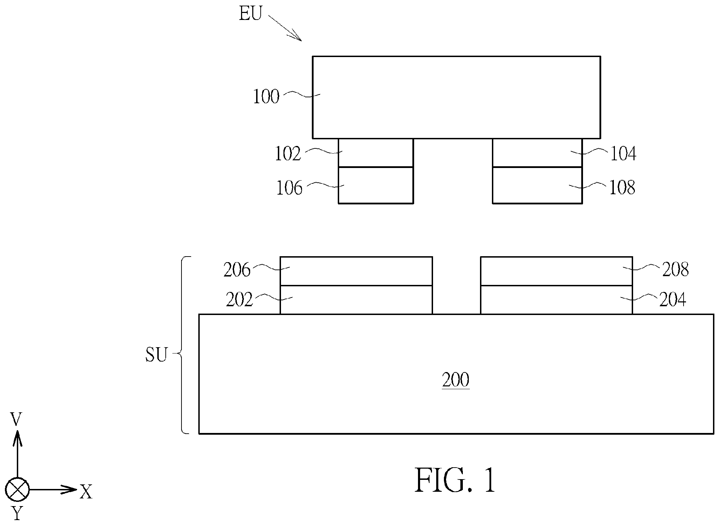

A direction V, a direction X, and a direction Y are shown in the following figures. The direction V may be a normal direction or a top view direction, and the direction X and the direction Y may be horizontal directions. As shown in FIG. 1, the direction V may be perpendicular to a surface (e.g., upper surface or bottom surface) of a basal substrate 200, the direction X and the direction Y may be perpendicular to the direction V or parallel to the surface of the basal substrate 200, and the direction X may be perpendicular to the direction Y The spatial relationship of structures can be described according to the direction V, the direction X, and direction Y in the following drawings.

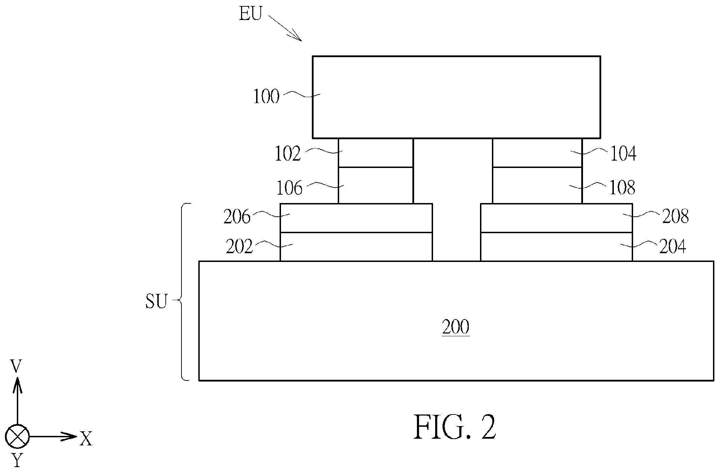

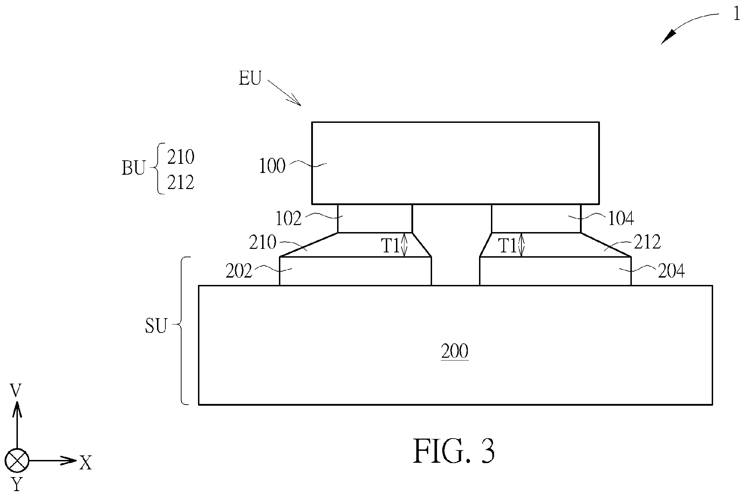

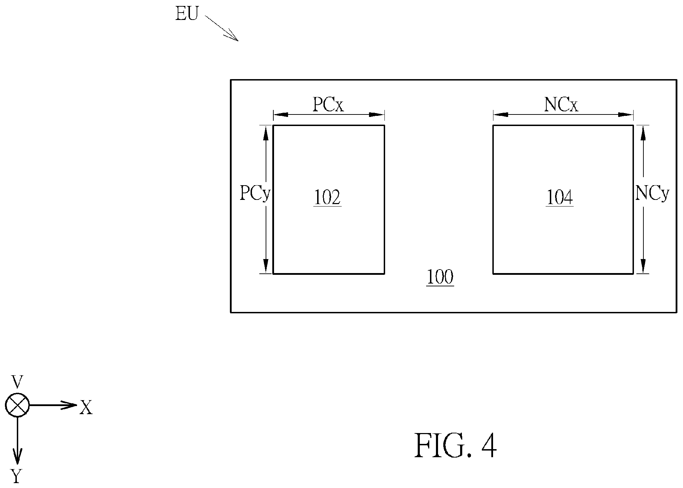

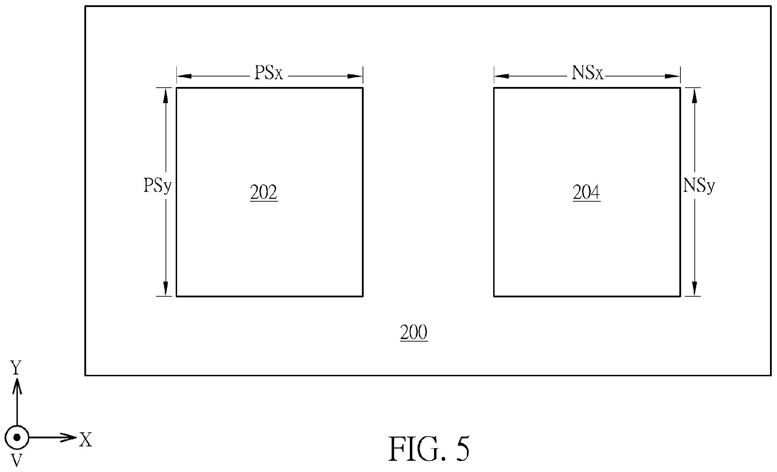

Refer to FIG. 1 to FIG. 5. FIG. 1 to FIG. 3 schematically illustrate a bonding process of an electronic device according to a first embodiment of the present disclosure. FIG. 1 schematically illustrates a state of an electronic unit and a substrate before bonding. FIG. 2 schematically illustrates a state of the electronic unit in contact with the substrate while intermetallic compound (IMC) is not formed yet. FIG. 3 schematically illustrates a state of the electronic unit and the substrate after bonding. FIG. 4 schematically illustrates a bottom view of an electronic unit according to the first embodiment of the present disclosure. FIG. 5 schematically illustrates a top view of a substrate according to the first embodiment of the present disclosure.

As shown in FIG. 1, an electronic unit EU and a substrate SU may be provided first, but not limited thereto. In some embodiments, the electronic unit EU may be a micro light emitting diode, but not limited thereto. In some embodiments, the electronic unit EU may be a flip chip type light emitting diode, but not limited thereto. The electronic unit EU includes a body 100, a bump metal layer 102, and a bump metal layer 104, but not limited thereto. The body 100 may include semiconductor materials, such as a P-type semiconductor material and an N-type semiconductor material, but not limited thereto. The bump metal layer 102 and the bump metal layer 104 are disposed on a bottom surface of the body 100, the bump metal layer 102 is electrically connected to one of the P-type semiconductor material and the N-type semiconductor material, and the bump metal layer 104 is electrically connected to the other one of the P-type semiconductor material and the N-type semiconductor material, but not limited thereto. As shown in FIG. 4 and FIG. 1, the bump metal layer 102 and the bump metal layer 104 are arranged in the direction X. Consequently, the bump metal layer 102 may be disposed at one side of the bump metal layer 104 in the direction X.

In this embodiment, a solder 106 is disposed under the bump metal layer 102, and a solder 108 is disposed under the bump metal layer 104. In the present disclosure, the solder may include tin, indium, a combination of the two, or other suitable elements, but not limited thereto. A range of the atomic percentage (at%) of tin (Sn) and indium (In) in the solder may be greater than 50%, which is (Sn at%+In at%)>50%.

The substrate SU includes a basal substrate 200, a bump metal layer 202, a bump metal layer 204, a conductive pad 206, and a conductive pad 208, but not limited thereto. The basal substrate 200 may be a flexible substrate or a rigid substrate, and a circuit layer may be disposed on the basal substrate 200, but not limited thereto. The circuit layer may include thin film transistor(s), wire(s), insulation layer(s) or a combination of the above, but not limited thereto. In addition, a material of the basal substrate 200 may include glass, quartz, sapphire, polymer (e.g., polyimide (PI), polyethylene terephthalate (PET)), silicon, silicon carbonate, gallium arsenide, other suitable material, or any combination of the aforementioned materials, but not limited thereto.

As shown in FIG. 5 and FIG. 1, the bump metal layer 202 and the bump metal layer 204 are disposed on the basal substrate 200, and the bump metal layer 202 and the bump metal layer 204 are arranged in the direction X. Consequently, the bump metal layer 202 may be disposed at one side of the bump metal layer 204 in the direction X. In the present disclosure, the bump metal layer may include a single-layered structure or a multi-layered structure, and a material of the bump metal layer may include titanium, nickel, gold, copper, palladium, platinum, aluminum, any combination of the aforementioned materials, or other suitable materials, but not limited thereto. The bump metal layer may provide functions of adhesion, blocking diffusion, etc. The material of the bump metal layer 102 and the bump metal layer 104 may be identical to or different from the material of the bump metal layer 202 and the bump metal layer 204.

The conductive pad 206 is disposed on the bump metal layer 202 and electrically connected to the bump metal layer 202, and the conductive pad 208 is disposed on the bump metal layer 204 and electrically connected to the bump metal layer 204. In the present disclosure, the conductive pad may include a single-layered structure or a multi-layered structure, and a material of the conductive pad may include metal or other suitable materials, but not limited thereto. In some embodiments, the material of the solder 106 and the solder 108 may be tin, and the material of the conductive pad 206 and the conductive pad 208 may be gold, but not limited thereto. In some embodiments, the material of the solder 106 and the solder 108 may be tin, and the material of the conductive pad 206 and the conductive pad 208 may be nickel, but not limited thereto. In some embodiments, the material of the solder 106 and the solder 108 may be tin, and the material of the conductive pad 206 and the conductive pad 208 may be copper, but not limited thereto. In some embodiments, the material of the solder 106 and the solder 108 may be indium, and the material of the conductive pad 206 and the conductive pad 208 may be gold, but not limited thereto.

Afterwards, as shown in FIG. 2, the solder 106 may be in direct contact with the conductive pad 206, and the solder 108 may be in direct contact with the conductive pad 208. Then, as shown in FIG. 3, after bonding, the electronic device 1 may include a bonding unit BU. The bonding unit BU includes a bonding member 210 and a bonding member 212, the bonding member 210 is disposed between the bump metal layer 202 and the bump metal layer 102, and the bonding member 212 is disposed between the bump metal layer 204 and the bump metal layer 104. In some examples, the solder 106 and the conductive pad 206 may be melted and mixed to form the bonding member 210, and the solder 108 and the conductive pad 208 may be melted and mixed to form the bonding member 212. The bonding member 210 and the bonding member 212 may, for example, be intermetallic compound, but not limited thereto. In some other examples, the solder may be melted but the conductive pad is not melted, and when the conductive pad contacts the melted solder, the two diffuse and mix with each other to form the bonding member, but not limited thereto. After bonding, the bump metal layer 102, the bonding member 210, and the bump metal layer 202 may be overlapped with each other in the direction V, and the bump metal layer 104, the bonding member 212, and the bump metal layer 204 may be overlapped with each other in the direction V. Besides, the bump metal layer 102 and the bump metal layer 104 of the electronic unit EU may respectively be electrically connected to the bump metal layer 202 and the bump metal layer 204 of the substrate SU through the bonding member 210 and the bonding member 212.

In this embodiment, as shown in FIG. 2, areas of the bump metal layer 102 and the bump metal layer 104 and areas of the solder 106 and the solder 108 may be less than areas of the bump metal layer 202 and the bump metal layer 204 and areas of the conductive pad 206 and the conductive pad 208, but not limited thereto. In some embodiments, the areas of the bump metal layer 102 and the bump metal layer 104 and the areas of the solder 106 and the solder 108 may be greater than the areas of the bump metal layer 202 and the bump metal layer 204 and the areas of the conductive pad 206 and the conductive pad 208, but not limited thereto.

As the solder 106 and the solder 108 are disposed under the bump metal layer 102 and the bump metal layer 104 that have less areas, and the areas of the solder 106 and the solder 108 are less than the areas of the conductive pad 206 and the conductive pad 208, the solder 106 and the solder 108 may spread out on the conductive pad 206 and the conductive pad 208 that have greater areas, under the bonding condition with a good wettability, such that thicknesses of the bonding member 210 and the bonding member 212 decrease, resulted in facing the risk of insufficient mechanical strength, which lowers the reliability of the electronic device.

Therefore, the present disclosure provides a design of the sizes of the electronic unit EU and the bonding member of the substrate SU to solve the above-mentioned problems. In this embodiment, the sizes of the solder 106 and solder 108 (e.g., area, length, or width) may be approximately the same as the sizes of the bump metal layer 102 and the bump metal layer 104, while the sizes of the conductive pad 206 and the conductive pad 208 may be approximately the same as the sizes of the bump metal layer 202 and the bump metal layer 204. Hence, designing the size of the bump metal layer may further determine the sizes of the solder and the conductive pad.

As shown in FIG. 4, the bump metal layer 102 has a width PCx and the bump metal layer 104 has a width NCx in the direction X, and the bump metal layer 102 has a width PCy and the bump metal layer 104 has a width NCy in the direction Y. In the present disclosure, the definition of the microscopic electronic unit EU may include the width PCx, the width PCy, the width NCx, and the width NCy are all greater than 5 micrometers (µm) and less than or equal to 36 micrometers individually. In addition, the size of the bump metal layer 102 may be different from the size of the bump metal layer 104. For example, as shown in FIG. 4, the width NCx may be greater than the width PCx, but not limited thereto. In some embodiments, the size of the bump metal layer 102 may be the same as the size of the bump metal layer 104.

As shown in FIG. 5, the bump metal layer 202 has a width PSx and the bump metal layer 204 has a width NSx in the direction X, and the bump metal layer 202 has a width PSy and the bump metal layer 204 has a width NSy in the direction Y The size of the bump metal layer 202 may be the same as the size of the bump metal layer 204, but not limited thereto. In some embodiments, the size of the bump metal layer 202 may be different from the size of the bump metal layer 204.

A ratio of the width PCx of the bump metal layer 102 to the width PSx of the bump metal layer 202 is greater than or equal to 0.3 and less than or equal to 0.9. A ratio of the width NCx of the bump metal layer 104 to the width NSx of the bump metal layer 204 is greater than or equal to 0.3 and less than or equal to 0.9. In some other embodiments, the ratio of the width PCx of the bump metal layer 102 to the width PSx of the bump metal layer 202 is greater than or equal to 0.5 and less than or equal to 0.8, and the ratio of the width NCx of the bump metal layer 104 to the width NSx of the bump metal layer 204 is greater than or equal to 0.5 and less than or equal to 0.8.

A ratio of the width PCy of the bump metal layer 102 to the width PSy of the bump metal layer 202 is greater than or equal to 0.1 and less than or equal to 0.9. A ratio of the width NCy of the bump metal layer 104 to the width NSy of the bump metal layer 204 is greater than or equal to 0.1 and less than or equal to 0.9. In some other embodiments, the ratio of the width PCy of the bump metal layer 102 to the width PSy of the bump metal layer 202 is greater than or equal to 0.2 and less than or equal to 0.8, and the ratio of the width NCy of the bump metal layer 104 to the width NSy of the bump metal layer 204 is greater than or equal to 0.2 and less than or equal to 0.8.

A ratio of an area of the bump metal layer 102 to an area of the bump metal layer 202 is greater than or equal to 0.1 and less than or equal to 0.64, and a ratio of an area of the bump metal layer 104 to an area of the bump metal layer 204 is greater than or equal to 0.1 and less than or equal to 0.64.

In some embodiments, when one of the width PCx and width PCy of the bump metal layer 102 and the width NCx and width NCy of the bump metal layer 104 is less than or equal to 5 micrometers, the electronic unit EU may be defined as extreme microscopic electronic unit. Under this circumstance, the ratio of the width PCx of the bump metal layer 102 to the width PSx of the bump metal layer 202, the ratio of the width NCx of the bump metal layer 104 to the width NSx of the bump metal layer 204, the ratio of the width PCy of the bump metal layer 102 to the width PSy of the bump metal layer 202, and the ratio of the width NCy of the bump metal layer 104 to the width NSy of the bump metal layer 204 may all be greater than or equal to 0.33 and less than or equal to 0.75. In addition, the ratio of the area of the bump metal layer 102 to the area of the bump metal layer 202 is greater than or equal to 0.11 and less than or equal to 0.56, and the ratio of the area of the bump metal layer 104 to the area of the bump metal layer 204 is greater than or equal to 0.11 and less than or equal to 0.56.

Because the sizes of the solder and the conductive pad may be determined by the design of the size of the bump metal layer, the above-mentioned proportional relations of the widths and areas of the bump metal layer 102 and the bump metal layer 104 to the widths and areas of the bump metal layer 202 and the bump metal layer 204 may be equal to the proportional relations of the widths and areas of the solder 106 and the solder 108 to the widths and areas of the conductive pad 206 and the conductive pad 208.

Furthermore, by the above-mentioned design of the sizes of the bump metal layer 102, the bump metal layer 104, the bump metal layer 202, and the bump metal layer 204, the change amplitude of the thickness of the contact point may be reduced. For example, as shown in FIG. 3, after bonding, a thickness T1 of the bonding member 210 or the bonding member 212 may be greater than or equal to 0.3 micrometers and less than or equal to 6.4 micrometers. The bonding member 210 and the bonding member 212 having this range of thickness may provide enough mechanical strength, so as to enhance the reliability of the electronic device 1.

Besides, in some embodiments, a portion of a surface (e.g., the surface in contact with the conductive pad or the solder) of the bump metal layer may be covered by an insulation layer. Under this condition, the aforementioned width or area of the bump metal layer may be measured according to the portion of the surface of the bump metal layer not covered by the insulation layer.

In some embodiments, the sizes (e.g., width or area) of the bump metal layer 102 and the bump metal layer 104 may be greater than the sizes of the bump metal layer 202 and the bump metal layer 204. When calculating the aforementioned ratio, the greater value (e.g., the width of the bump metal layer 102) may be the denominator, and the lesser value (e.g., the width of the bump metal layer 202) may be the numerator, such that the above-mentioned ratio range may be obtained.

It can be apprehended from the aforementioned contents that, in some embodiments, an electronic device 1 may include the substrate SU, the electronic unit EU, and the bonding unit BU. The substrate SU includes the bump metal layer 202 and the bump metal layer 204, and the bump metal layer 202 and the bump metal layer 204 are arranged in the direction X. The electronic unit EU includes the bump metal layer 102 and the bump metal layer 104, the bump metal layer 202 is overlapped with the bump metal layer 102, and the bump metal layer 204 is overlapped with the bump metal layer 104. The bonding unit BU includes the bonding member 210 and the bonding member 212, the bonding member 210 is disposed between the bump metal layer 202 and the bump metal layer 102, and the bonding member 212 is disposed between the bump metal layer 204 and the bump metal layer 104. In the direction X, the ratio of the width PCx of the bump metal layer 102 to the width PSx of the bump metal layer 202 is greater than or equal to 0.3 and less than or equal to 0.9. Although the electronic unit EU of the electronic device 1 is a microscopic electronic unit (e.g., micro LED), the electronic unit EU and the substrate SU may still have high bonding strength, such that the electronic device 1 may have high reliability.

The contents of the present disclosure are not limited to the aforementioned embodiment. The following description details other embodiments. To simplify the description and show the difference between other embodiments and the above-mentioned embodiment, identical components in each of the following embodiments are marked with identical symbols, and the identical features will not be redundantly described.

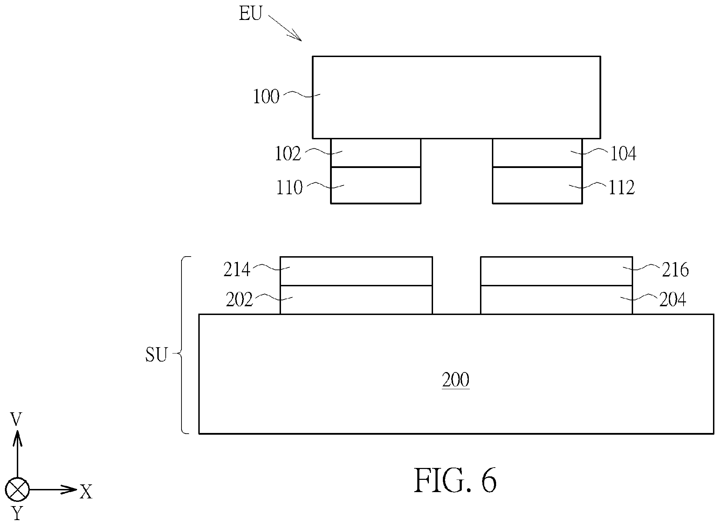

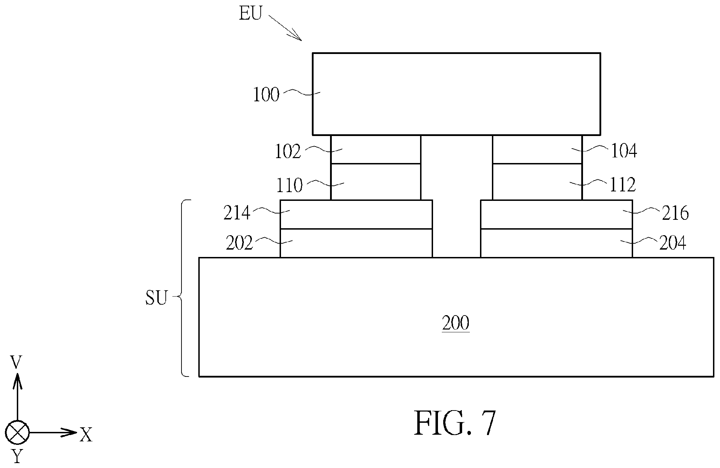

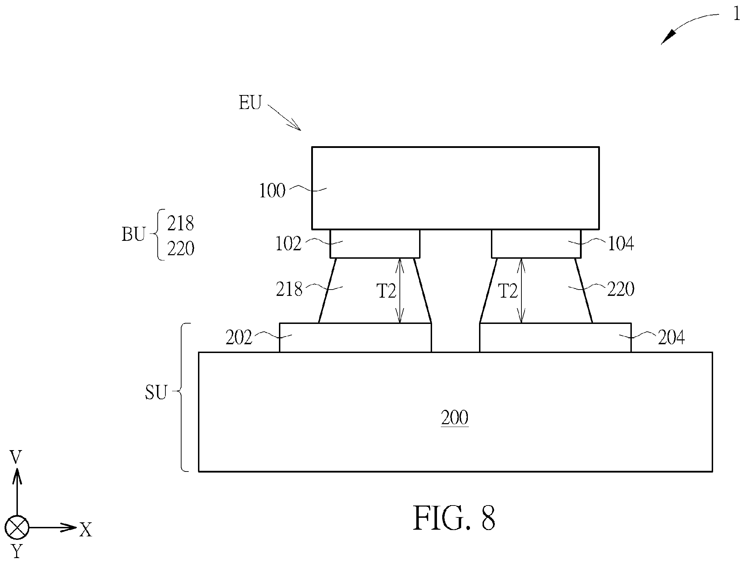

Refer to FIG. 6 to FIG. 8. FIG. 6 to FIG. 8 schematically illustrate a bonding process of an electronic device according to a second embodiment of the present disclosure. FIG. 6 schematically illustrates a state of the electronic unit and the substrate before bonding. FIG. 7 schematically illustrates a state of the electronic unit in contact with the substrate while intermetallic compound is not formed yet. FIG. 8 schematically illustrates a state of the electronic unit and the substrate after bonding. In this embodiment, the locations of the solder and the conductive pad are different from that in the first embodiment. As shown in FIG. 6, the electronic unit EU includes a conductive pad 110 and a conductive pad 112, the conductive pad 110 is disposed under the bump metal layer 102, and the conductive pad 112 is disposed under the bump metal layer 104. In addition, a solder 214 is disposed on the bump metal layer 202 of the substrate SU, and a solder 216 is disposed on the bump metal layer 204 of the substrate SU.

In some embodiments, the material of the solder 214 and the solder 216 may be tin, and the material of the conductive pad 110 and the conductive pad 112 may be gold, but not limited thereto. In some embodiments, the material of the solder 214 and the solder 216 may be tin, and the material of the conductive pad 110 and the conductive pad 112 may be nickel, but not limited thereto. In some embodiments, the material of the solder 214 and the solder 216 may be tin, and the material of the conductive pad 110 and the conductive pad 112 may be copper, but not limited thereto. In some embodiments, the material of the solder 214 and the solder 216 may be indium, and the material of the conductive pad 110 and the conductive pad 112 may be gold, but not limited thereto.

In this embodiment, the size of the bump metal layer 102 and the size of the bump metal layer 104 may be the same, the sizes (e.g., area, length, or width) of the conductive pad 110 and the conductive pad 112 may be approximately the same as the sizes of the bump metal layer 102 and the bump metal layer 104, and the sizes of the solder 214 and the solder 216 may be approximately the same as the sizes of the bump metal layer 202 and the bump metal layer 204. In addition, the areas of the bump metal layer 102 and the bump metal layer 104 and the areas of the conductive pad 110 and the conductive pad 112 may be less than the areas of the bump metal layer 202 and the bump metal layer 204 and the areas of the solder 214 and the solder 216, but not limited thereto. Nonetheless, in some embodiments, the areas of the bump metal layer 102 and the bump metal layer 104 and the areas of the conductive pad 110 and the conductive pad 112 may be greater than the areas of the bump metal layer 202 and the bump metal layer 204 and the areas of the solder 214 and the solder 216, but not limited thereto.

Afterwards, as shown in FIG. 7, the solder 214 may be in direct contact with the conductive pad 110, and the solder 216 may be in direct contact with the conductive pad 112. Then, as shown in FIG. 8, after bonding, the bonding unit BU of the electronic device 1 includes a bonding member 218 and a bonding member 220, the bonding member 218 is disposed between the bump metal layer 202 and the bump metal layer 102, and the bonding member 220 is disposed between the bump metal layer 204 and the bump metal layer 104. In some examples, the solder 214 and the conductive pad 110 may be melted and mixed to form the bonding member 218, the solder 216 and the conductive pad 112 may be melted and mixed to form the bonding member 220, and the bonding member 210 and the bonding member 212 may, for example, be intermetallic compound, but not limited thereto. In some other examples, the solder may be melted but the conductive pad is not melted, and when the conductive pad contacts the melted solder, the two diffuse and mix with each other to form the bonding member, but not limited thereto. After bonding, the bump metal layer 102, the bonding member 218, and the bump metal layer 202 may be overlapped with each other in the direction V, and the bump metal layer 104, the bonding member 220, and the bump metal layer 204 may be overlapped with each other in the direction V. Besides, the bump metal layer 102 and the bump metal layer 104 of the electronic unit EU may respectively be electrically connected to the bump metal layer 202 and the bump metal layer 204 of the substrate SU through the bonding member 218 and the bonding member 220.

As the solder 214 and the solder 216 are disposed on the bump metal layer 202 and the bump metal layer 204 that have greater areas, and the areas of the conductive pad 110 and the conductive pad 112 are less than the areas of the solder 214 and the solder 216, the solder 214 and the solder 216 will gather inwards when being melted, such that the thicknesses of the bonding member 218 and the bonding member 220 are bigger than expected. When the thicknesses of the bonding member 218 and the bonding member 220 are too thick, the bonding member 218 and the bonding member 220 still face the risk of fragility and insufficient mechanical strength, lowering the reliability of the electronic device.

However, like the first embodiment, the bump metal layer 102, the bump metal layer 104, the bump metal layer 202, and the bump metal layer 204 may as well have the same design of the ratio of width and area. Because the sizes of the solder and the conductive pad may be determined by the design of the size of the bump metal layer, a proportional relation of the widths and the areas of the bump metal layer 102 and the bump metal layer 104 to the widths and the areas of the bump metal layer 202 and the bump metal layer 204 may be equal to the proportional relation of the widths and the areas of the conductive pad 110 and the conductive pad 112 to the widths and the areas of the solder 214 and the solder 216. By these design, the change amplitude of the thickness of the contact point may be reduced. For example, as shown in FIG. 8, after bonding, a thickness T2 of the bonding member 218 or the bonding member 220 may be greater than or equal to 0.3 micrometers and less than or equal to 6.4 micrometers. The bonding member 210 and the bonding member 212 having this range of thickness may provide enough mechanical strength, so as to enhance the reliability of the electronic device 1.

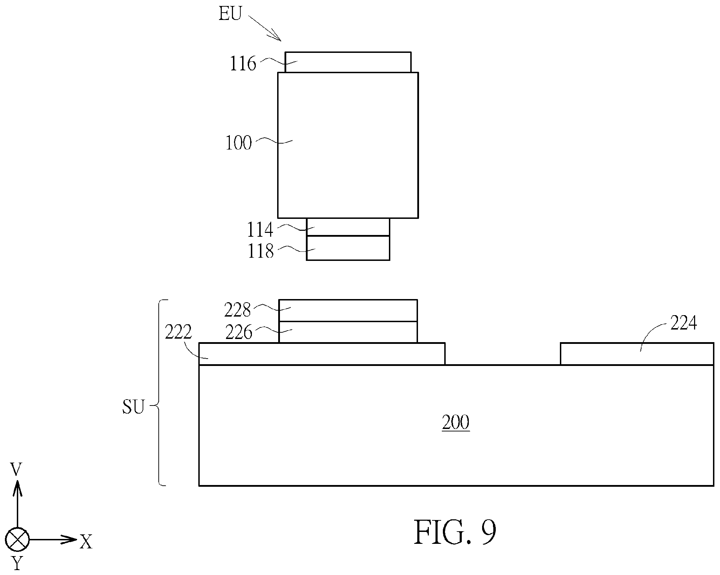

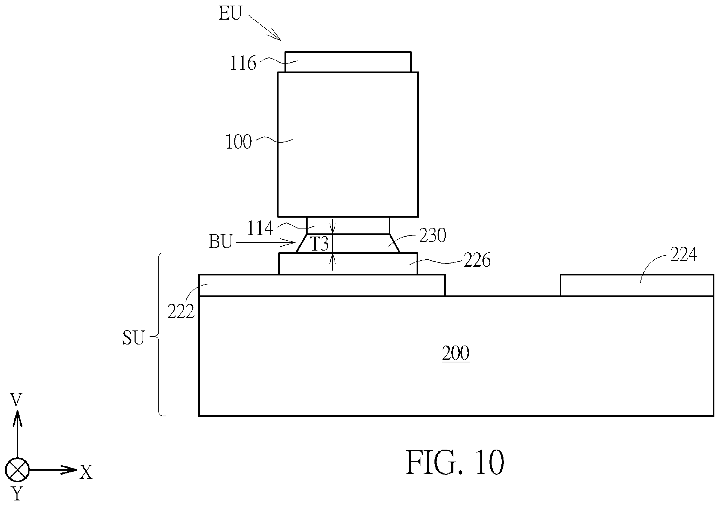

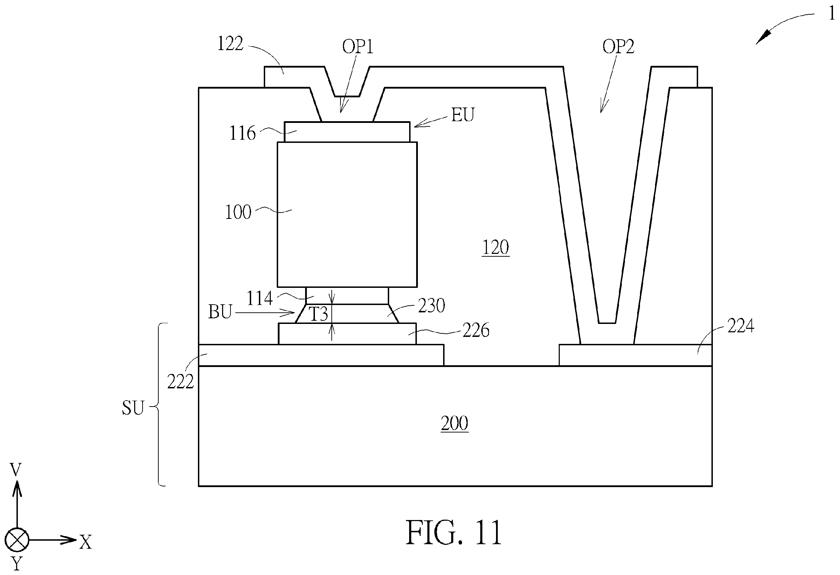

Refer to FIG. 9 to FIG. 11. FIG. 9 to FIG. 11 schematically illustrate a bonding process of an electronic device according to a third embodiment of the present disclosure. FIG. 9 schematically illustrates a state of the electronic unit and the substrate before bonding. FIG. 10 schematically illustrates a state of the electronic unit and the substrate after bonding. FIG. 11 schematically illustrates a state after a connection wire is formed. A difference between this embodiment and the first embodiment is that the electronic unit of this embodiment is a vertical type LED. The electronic unit EU includes the body 100, a bump metal layer 114, and an electrode 116, but not limited thereto. The bump metal layer 114 and the electrode 116 are respectively disposed on two sides of the body 100. For example, the electrode 116 is disposed on an upper surface of the body 100, and the bump metal layer 114 is disposed on the bottom surface of the body 100, but not limited thereto. The bump metal layer 114 may be electrically connected to one of the P-type semiconductor material and the N-type semiconductor material of the body 100, and the electrode 116 may be electrically connected to the other one of the P-type semiconductor material and the N-type semiconductor material, but not limited thereto. Besides, a solder 118 may be disposed on a bottom surface of the bump metal layer 114, but not limited thereto.

The substrate SU includes the basal substrate 200, a wire 222, a wire 224, a bump metal layer 226, and a conductive pad 228, but not limited thereto. The wire 222 and the wire 224 are disposed on the basal substrate 200 and arranged in the direction X. Hence, the wire 222 may be disposed at one side of the wire 224 in the direction X. The bump metal layer 226 is disposed on the wire 222. Consequently, the bump metal layer 226 and the wire 224 are arranged in the direction X. In addition, the conductive pad 228 may be disposed on an upper surface of the bump metal layer 226, but not limited thereto. The conductive pad 228 is electrically connected to the bump metal layer 226, and the bump metal layer 226 is electrically connected to the wire 222. Before bonding, the bump metal layer 226, the conductive pad 228, the solder 118, and the bump metal layer 114 may be overlapped with each other in the direction V.

In some embodiments, the conductive pad 228 may be disposed on the bottom surface of the bump metal layer 114, and the solder 118 may be disposed on the upper surface of the bump metal layer 226, but not limited thereto.

Afterwards, the solder 118 may be in direct contact with the conductive pad 228. Then, as shown in FIG. 10, after bonding, the bonding unit BU of the electronic device 1 includes a bonding member 230, and the bonding member 230 is disposed between the bump metal layer 226 and the bump metal layer 114. In some examples, the solder 118 and the conductive pad 228 may be melted and mixed to form the bonding member 230. In some other examples, the solder may be melted but the conductive pad is not melted, and when the conductive pad contacts the melted solder, the two diffuse and mix with each other to form the bonding member, but not limited thereto. The bonding member 230 may, for example, be intermetallic compound, but not limited thereto. After bonding, the bump metal layer 114, the bonding member 230, and the bump metal layer 226 may be overlapped with each other in the direction V. Besides, the bump metal layer 114 of the electronic unit EU may be electrically connected to the bump metal layer 226 and the wire 222 of the substrate SU through the bonding member 230.

Like the first embodiment, the bump metal layer 114 of the electronic unit EU and the bump metal layer 226 of the substrate SU of this embodiment may as well have the same design of the ratio of their widths and areas. The proportional relation, i.e. ratio, of the width and area of the bump metal layer 114 to the width and area of the bump metal layer 226 in this embodiment may be the same as the proportional relation, i.e. ratio, of the width and area of the bump metal layer 102 to the width an area of the bump metal layer 202 in the first embodiment. Because the sizes of the solder and the conductive pad may be determined by the design of the size of the bump metal layer, the proportional relation of the width and area of the bump metal layer 114 to the width and area of the bump metal layer 226 may be equal to the proportional relation of the width and area of the solder 118 to the width and area of the conductive pad 228. By these design, the change amplitude of the thickness of the contact point may be reduced. For example, as shown in FIG. 10, after bonding, a thickness T3 of the bonding member 230 may be greater than or equal to 0.3 micrometers and less than or equal to 6.4 micrometers. The bonding member 230 having this range of thickness may provide enough mechanical strength, so as to enhance the reliability of the electronic device 1.

Afterwards, as shown in FIG. 11, an insulation layer 120 is formed on the substrate SU and the electronic unit EU, and the insulation layer 120 may cover the substrate SU and the electronic unit EU. The insulation layer 120 includes an opening OP1 and an opening OP2. The opening OP1 may expose a portion of an upper surface of the electrode 116 of the electronic unit EU, and the opening OP2 may expose a portion of an upper surface of the wire 224. Then, a connection wire 122 is formed on the insulation layer 120, and the connection wire 122 may extend into the opening OP1 and the opening OP2 to be in contact with the electrode 116 and the wire 224. Hence, the connection wire 122 may be electrically connected to the electrode 116 of the electronic unit EU and the wire 224 of the substrate SU.

In some embodiments, the connection wire 122, the electrode 116 of the electronic unit EU, and the wire 222 and the wire 224 of the substrate SU may include metal, transparent conductive material, or other suitable conductive materials, but not limited thereto.

It can be apprehended from the aforementioned contents that, in this embodiment, an electronic device 1 may include the substrate SU, the electronic unit EU, the bonding unit BU, and the connection wire 122. The substrate SU includes the bump metal layer 226 and the wire 224, wherein the bump metal layer 226 and the wire 224 are arranged in the direction X. The electronic unit EU includes the body 100, the bump metal layer 114, and the electrode 116, the bump metal layer 114 and the electrode 116 are disposed on two sides of the body 100, and the bump metal layer 226 is overlapped with the bump metal layer 114. The bonding unit BU includes the bonding member 230, wherein the bonding member 230 is disposed between the bump metal layer 226 and the bump metal layer 114. The connection wire 122 is electrically connected to the electrode 116 of the electronic unit EU and the wire 224 of the substrate SU. In the direction X, the ratio of the width of the bump metal layer 114 to the width of the bump metal layer 226 is greater than or equal to 0.3 and less than or equal to 0.9.

In summary, in the electronic device of the present disclosure, by the design of the size of the bump metal layer of the microscopic electronic unit and the design of the size of the bump metal layer of the substrate, the change amplitude of the thickness of the bonding member formed by melted and mixed solder and conductive pad may be reduced, such that the bonding member may provide enough mechanical strength and the reliability of the electronic device may be enhanced.

## Claims

1. An electronic device (1), **characterized by** comprising:
a substrate (200) comprising a first bump metal layer (202) and a second bump metal layer (204), wherein the first bump metal layer (202) and the second bump metal layer (204) are arranged in a first direction (X);
an electronic unit (EU) comprising a third bump metal layer (102) and a fourth bump metal layer (104), wherein the first bump metal layer (202) is overlapped with the third bump metal layer (102), and the second bump metal layer (204) is overlapped with the fourth bump metal layer (104); and
a bonding unit (BU) comprising a first bonding member (210) and a second bonding member (212), wherein the first bonding member (210) is disposed between the first bump metal layer (202) and the third bump metal layer (102), and the second bonding member (212) is disposed between the second bump metal layer (204) and the fourth bump metal layer (104);
wherein in the first direction (X), a ratio of a width (PCx) of the third bump metal layer (102) to a width (PSx) of the first bump metal layer (202) is greater than or equal to 0.3 and less than or equal to 0.9.

2. The electronic device (1) according to claim 1, **characterized in that** the ratio of the width (PCx) of the third bump metal layer (102) to the width (PSx) of the first bump metal layer (202) in the first direction (X) is greater than or equal to 0.5 and less than or equal to 0.8.

3. The electronic device (1) according to claim 1 or claim 2, **characterized in that** in a second direction (Y) perpendicular to the first direction (X), a ratio of a width (PCy) of the third bump metal layer (102) to a width (PSy) of the first bump metal layer (202) is greater than or equal to 0.1 and less than or equal to 0.9.

4. The electronic device (1) according to claim 3, **characterized in that** the ratio of the width (PCy) of the third bump metal layer (102) to the width (PSy) of the first bump metal layer (202) in the second direction (Y) is greater than or equal to 0.2 and less than or equal to 0.8.

5. The electronic device (1) according to any one of claim 1 to claim 4, **characterized in that** a ratio of an area of the third bump metal layer (102) to an area of the first bump metal layer (202) is greater than or equal to 0.1 and less than or equal to 0.64.

6. The electronic device (1) according to any one of claim 1 and claim 3 to claim 5, **characterized in that** when the width (PCx) of the third bump metal layer (102) is less than or equal to 5 micrometers, the ratio of the width (PCx) of the third bump metal layer (102) to the width (PSx) of the first bump metal layer (202) in the first direction (X) is greater than or equal to 0.33 and less than or equal to 0.75.

7. The electronic device (1) according to any one of claim 1 to claim 6, **characterized in that** a ratio of an area of the third bump metal layer (102) to an area of the first bump metal layer (202) is greater than or equal to 0.11 and less than or equal to 0.56.

8. The electronic device (1) according to any one of claim 1 to claim 7, **characterized in that** a thickness (T1) of the first bonding member (210) or a thickness (T1) of the second bonding member (212) is greater than or equal to 0.3 micrometers and less than or equal to 6.4 micrometers.

9. The electronic device (1) according to any one of claim 1 to claim 8, **characterized in that** the electronic unit (EU) is a flip chip type light emitting diode.

10. The electronic device (1) according to any one of claim 1 to claim 9, **characterized in that** each of the first bonding member (210) and the second bonding member (212) is intermetallic compound.

11. An electronic device (1), **characterized by** comprising:
a substrate (200) comprising a first bump metal layer (226) and a wire (224), wherein the first bump metal layer (226) and the wire (224) are arranged in a first direction (X);
an electronic unit (EU) comprising a body (100), a second bump metal layer (114), and an electrode (116), wherein the second bump metal layer (114) and the electrode (116) are respectively disposed on two sides of the body (100), and the first bump metal layer (226) is overlapped with the second bump metal layer (114);
a bonding unit (BU) comprising a bonding member (230), wherein the bonding member (230) is disposed between the first bump metal layer (226) and the second bump metal layer (114); and
a connection wire (122) electrically connected to the electrode (116) of the electronic unit (EU) and the wire (224) of the substrate (200);
wherein in the first direction (X), a ratio of a width of the second bump metal layer (114) to a width of the first bump metal layer (226) is greater than or equal to 0.3 and less than or equal to 0.9.

12. The electronic device (1) according to claim 11, **characterized by** further comprising an insulation layer (120) disposed on the electronic unit (EU) and the substrate (200), wherein the insulation layer (120) covers the electronic unit (EU) and the substrate (200), the insulation layer (120) comprises a first opening (OP1) and a second opening (OP2), the first opening (OP1) exposes a portion of an upper surface of the electrode (116) of the electronic unit (EU), and the second opening (OP2) exposes a portion of an upper surface of the wire (224).

13. The electronic device (1) according to claim 12, **characterized in that** the connection wire (122) is disposed on the insulation layer (120).

14. The electronic device (1) according to claim 13, **characterized in that** the connection wire (122) extends into the first opening (OP1) to be in contact with the electrode (116), and the connection wire (122) extends into the second opening (OP2) to be in contact with the wire (224).

15. The electronic device (1) according to any one of claim 11 to claim 14, **characterized in that** the bonding member (230) is intermetallic compound.
